Europäisches Patentamt

European Patent Office

Office européen des brevets

(11) Veröffentlichungsnummer: **0 181 556**
**A1**

## (12) EUROPÄISCHE PATENTANMELDUNG

(21) Anmeldenummer: 85113708.3

(22) Anmeldetag: 28.10.85

(51) Int. Cl.⁴: **H05K 13/04**

(30) Priorität: 02.11.84 DE 3440168

(43) Veröffentlichungstag der Anmeldung:
**21.05.86 Patentblatt 86/21**

(84) Benannte Vertragsstaaten:
**CH DE FR GB IT LI SE**

(71) Anmelder: **Siemens Aktiengesellschaft
Berlin und München Wittelsbacherplatz 2
D-8000 München 2(DE)**

(72) Erfinder: **Schneider, Bernd
Harthauserstrasse 79
D-8000 München 90(DE)**

(54) **Bestückautomat für Sonderbauteile.**

(57) Das Ziel der Erfindung ist das automatische Bestücken von Leiterplatten mit einem Typenspektrum von Sonderbauteilen. Hierzu dient ein von einem Industrieroboter bewegter Greifer, der einen xy-Schlitten bewegt, auf den die Leiterplatten von dem Industrieroboter-Greifer zur Bestückung abgelegt werden. Die Bauteile sind vorzugsweise in linearen Magazinen angeordnet und werden durch eine schwenkbare Wiege in Bauelemente-Greifern über die Leiterplatte gebracht und dort programmiert eingesetzt. Unter dem Schlitten befindet sich eine Anordnung von auf das jeweilige Bauteil abgestimmten Biegewerkzeugen, die die Bauteilebeinchen nach dem Einsetzen umbiegen und dabei eine Beinchendurchsteckprüfung ermöglichen.

FIG 1

EP 0 181 556 A1

Bestückautomat für Sonderbauteile.

Die Erfindung betrifft eine Anordnung und ein Verfahren zum automatischen Bestücken von Leiterplatten mit einem großen Bauelemente-Typenspektrum mittels eines durch einen Industrieroboter gesteuerten Greifer und einer Anordnung zum Umbiegen der Bauteilebeinchen.

Es gibt eine große Anzahl von Bestückautomaten für Standardbauteile (IC's, Widerstände und so weiter), die in den Elektronikfertigungen breite Anwendung gefunden haben. Ein fertigungsreifes Konzept für einen Bestückautomaten für ein größeres Typenspektrum von Sonderbauteilen mit Anschlußbeinchen (zum Beispiel 20) ist bisher nicht bekannt.

Die bisher auf Messen und Ausstellungen gezeigten Versuchsgeräte arbeiten fast durchweg mit Industrierobotern nach dem pick-and-place-Prinzip. Bisher sind Versuchsgeräte bekannt, bei denen die Bauteile von einem Industrieroboter aus Magazinen entnommen und in eine feststehende Leiterplatte eingesetzt werden (zum Beispiel "Robotics today", Dezember 1983: "Robotic Assembly in Electronics Manufacturing").

Dabei trägt der Roboterarm einen Greifer, der aus Bereitstellungsstationen Bauteile entnimmt und diese in das Lochraster einer feststehenden Leiterplatte einsetzt. Dieses Konzept hat aber eine Reihe von Nachteilen:

a) Lange Taktzeiten durch den sequentiellen Ablauf der Einsetzroutine: Greifen des Bauteiles, Anheben aus der Bereitstellungsstation, Anlaufen der Einsetzposition, Einsetzen, Bauteilbeinchen unter der Leiterplatte biegen, Greifer öffnen, Greifer zurückfahren, neue Bereitstellungsstation anlaufen, Greifer absenken.

b) Hoher mechanischer und zeitlicher Aufwand beim Bauteiltypenwechsel: Bei Bauteilen mit unterschiedlichen Abmessungen muß der Bauteilgreifer am Roboterarm automatisch gewechselt werden. Dies führt zu weiterer Verlangsamung der Taktzeit und bei einem größeren Typenspektrum zu hohem Aufwand. Der Einsatz von nicht genau auf das Bauteil abgestimmten Universalgreifern führt dagegen zu Einsetzzuverlässigkeitsproblemen.

c) Hoher mechanischer Aufwand für das Festlegen der Bauelemente durch Abbiegen der Bauelemente-Beinchen: Eine unter der Leiterplatte angebrachte Biegevorrichtung muß jede Position des Lochrasters der Leiterplatte erreichen (bei größeren LP's mehr als 7000 Positionen) und die Beinchen in verschiedenen Richtungen biegen können. Soll eine Beinchendurchsteckprüfung vorgenommen werden, wird der Aufwand noch größer.

Der Erfindung liegt die Aufgabe zugrunde, die eingangs definierte Anordnung und ein Verfahren zum automatischen Bestücken von Leiterplatten mit Sonderbauteilen zu konzipieren. Das Konzept soll eine schnelle Bestückung von Leiterplatten mit einem großen Bauteile-Typenspektrum ermöglichen.

Diese Aufgabe wird durch die in den Patentansprüchen aufgeführten Merkmale gelöst.

Das Konzept nach der Erfindung hat gegenüber dem eingangs beschriebenen pick-and-place-Verfahren vor allem Vorteile im Hinblick auf Taktzeit und Zuverlässigkeit. Das sind aber wichtige Merkmale für derartige Einsetzautomaten. Die Taktzeitverkürzung resultiert aus einer Verringerung der für das Einsetzen der Bauteile erforderlichen Arbeitsgänge von 9 auf 5 unter a) (Anlaufen der Einsetzposition, Einsetzen, Bauteil-Beinchen unter der Leiterplatte biegen, Greifer öffnen, Greifer zurückfahren).

Die erhöhte Zuverlässigkeit ergibt sich aus der Tatsache, daß Bauteilbereitstellung, Richtstation, Greifer und Biegewerkzeug genau auf das jeweilige Bauelement abgestimmt werden.

Die Erfindung wird anhand der Figuren erläutert. Es zeigen:

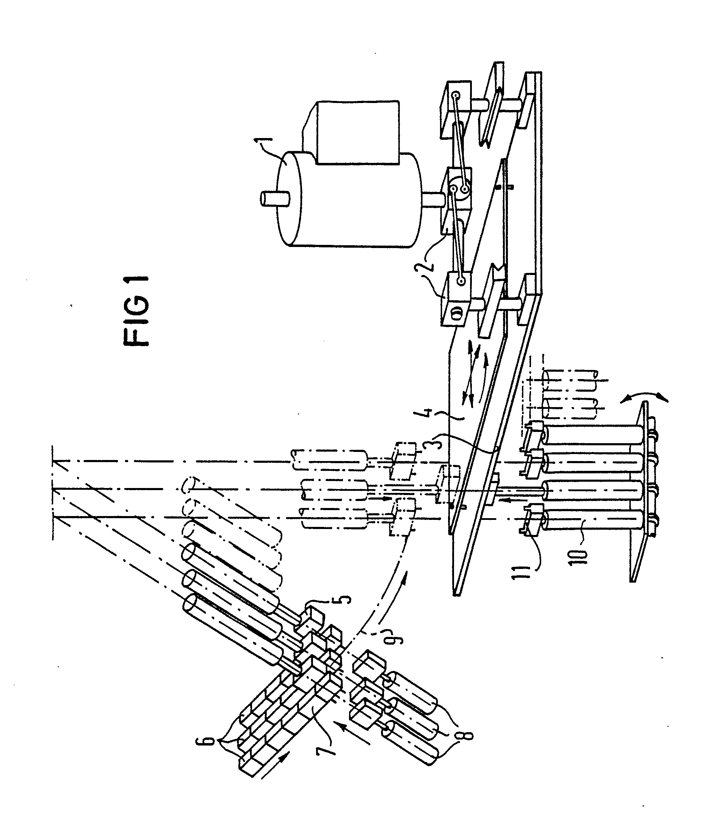

Figur 1 eine schematische Darstellung eines Bestückautomaten und

Figur 2 eine schematische Darstellung der Beinchendurchsteckprüfung und Umbiegefunktion.

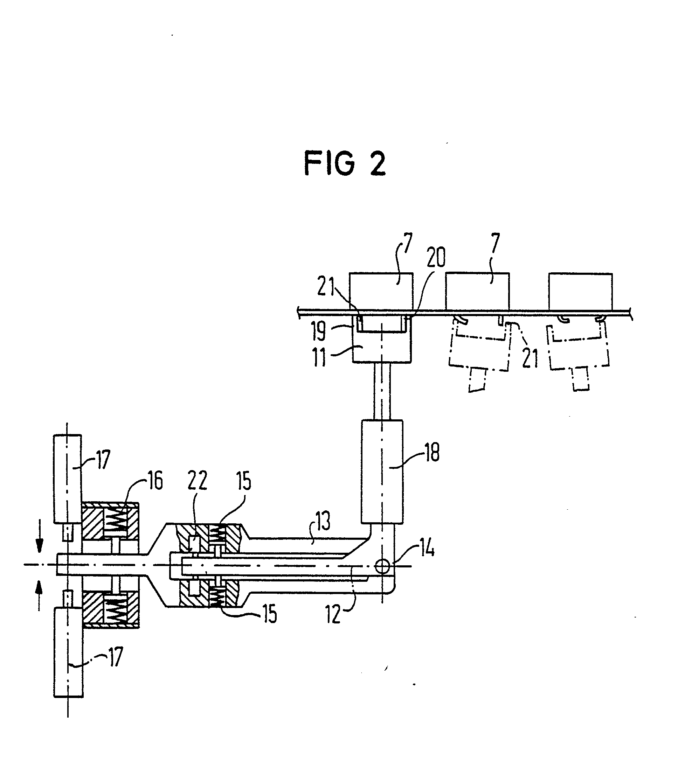

An einem Industrieroboter 1 ist ein Greifer 2 montiert, der den in x, y-Richtung und ʃ verschiebbaren und drehbaren Schlitten 3 bewegt. Auf diesem Schlitten befindet sich bereits eine von dem Industrieroboter-Greifer eingesetzte Leiterplatte 4. Vor diesem Schlitten sind die Sonderbauteile 7 in linearen Magazinen 6 angeordnet. Die Sonderbauteile 7 werden von Richtstationen 8 in Bauteile-Greifer 5 übergeben und von einer Wiege 9 über die Leiterplatte 4 geschwenkt. Unter dem Schlitten 3 ist eine Beinchenbiegeeinheit 10 mit Biegeköpfen 11 angedeutet, die in der Figur 2 näher dargestellt ist.

Die Figur 2 zeigt eine Seitenansicht der Beinchenbiegeeinheit. Die Hebelsysteme 12 und 13 sind im Punkt 14 gelagert. Sie werden durch federnde, vorgespannte Anschläge 15 und 16 in der Mittellage gehalten. Biegezylinder 17 bewegen abwechselnd die beiden Hebelsysteme 12, 13, wenn einer der Zylinder 18 mit dem Biegekopf 11 hochgefahren ist. Die Beinchen 19 und 20 werden getrennt durch Biegebacken 21 abgebogen. Mit 22 sind Schalter bezeichnet.

Der Industrieroboter 1 holt mit seinem Greifer 2 eine mit Sonderbauteilen zu bestückende Leiterplatte 4 aus einer nicht dargestellten Eingabestation und setzt sie in den nicht angetriebenen, zunächst verriegelten x-y-Schlitten mit einem Drehteller ein. Vor diesem Schlitten sind in Bauteile-Magazinen 6 eine große Auswahl verschiedener Bauteiletypen aufgereiht (zum Beispiel 25 Typen). Auf der schwenkbaren Wiege 9 sind über den Bauteile-Magazinen eine gleich große Anzahl von genau auf das jeweilige Bauteil abgestimmten Bauteile-Greifern 5 angeordnet.

Während der Industrieroboter 1 mit dem Greifer 2 die Leiterplatte 4 in den Schlitten 3 bringt, werden die Bauteile-Typen, mit denen die Leiterplatte bestückt werden soll, von den Richtstationen 8 in die Bauteile-Greifer 5 übergeben. Dabei werden die Bauteile-Beinchen ausgerichtet. Danach schwenkt die Wiege 9 mit den Bauteile bestückten Greifern über die in dem Schlitten fixierte Leiterplatte. Inzwischen hat sich der Industrieroboter mit dem Industrieroboter-Greifer 2 an den x-y-Schlitten angekoppelt und bewegt Schlitten und Drehteller und damit die Leiterplatte in die Bestückpositionen unter die Bauteile-Greifer 5. Dort werden die Bauteile nacheinander eingesetzt.

Nach dem Einsetzen eines Bauteils werden die Beinchen durch wiederum speziell auf das jeweilige Bauteil abgestimmte Biegeköpfe gebogen und damit das Bauteil auf der Leiterplatte fixiert. Die Biegeköpfe sind auf einem Pendelsystem nach der Figur 2 angeordnet, das so ausgebildet ist, daß eine Beinchendurchsteckprüfung ermöglicht wird.

Ein im Punkt 14 gelagertes Hebelsystem 13 wird von den federnden Anschlägen 16 in der in der Figur 2 gezeigten Mittellage gehalten. Wenn das Bauteil in die Leiterplatte eingesetzt ist, fährt von mehreren, am Hebelsystem angeordneten Zylindern derjenige hoch, der den auf das Bauteil abgestimmten Biegekopf trägt. Die Biegebacken 21 stehen dann rechts und links von den Bauteile-Beinchen.

Nun wird der Biegezylinder 17 betätigt und bewegt das Hebelsystem gegen den Anschlag 16 nach unten. Nur wenn ein Bauteil-Beinchen vorhanden ist, wird der Hebel 12 durch die Biegekraft gegen die federnden Anschläge 15 ausgelenkt und betätigt den Schalter 22. Der Vorgang wiederholt sich für das andere Beinchen in derselben Reihenfolge.

**Ansprüche**

1. Anordnung zum automatischen Bestücken von Leiterplatten mit einem großen Bauteile-Typenspektrum mittels eines durch einen Industrieroboter gesteuerten Greifer und einer Anordnung zum Umbiegen der Bauteilebeinchen, **dadurch gekennzeichnet,** daß zur Aufnahme der Leiterplatten (4) aus einer Eingabestation im Bereich des Industrieroboter-Greifers (2) ein in x-y-Richtung verschiebbarer Schlitten (3) mit einem Drehteller vorgesehen ist und der Industrieroboter-Greifer einerseits die Leiterplatten erfaßt und andererseits den Schlitten und den Drehteller bewegt, daß ferner an einer Seite vor diesem Schlitten (3) die Bauteile vorzugsweise in linearen Magazinen (6) aufgereiht sind und auf einer schwenkbaren Wiege (9) über den Bauteilen eine gleich große Anzahl von genau auf das jeweilige Bauteil abgestimmten Bauteile-Greifern (5) angeordnet sind und daß sich unter dem Schlitten (3) auf das jeweilige Bauteil abgestimmte Biegeköpfe (11) zum Abbiegen der Beinchen der Bauteile nach dem Einsetzen in die Leiterplatte befinden.

2. Anordnung nach Anspruch 1, **dadurch gekennzeichnet,** daß die Biegeköpfe (11) von einem Hebelsystem (12, 13) bewegten Pendelsystem gesteuert sind, das eine Beinchendurchsteckprüfung ermöglicht.

3. Anordnung nach Anspruch 2, **dadurch gekennzeichnet,** daß zur Betätigung des Hebelsystems (12, 13) Biegezylinder (17), Biegekopfzylinder (18), vorgespannte federnde Anschläge (15, 16) und Schalter (22) vorgesehen sind.

4. Anordnung nach Anspruch 3, **dadurch gekennzeichnet,** daß das Hebelsystem (12) zum Abbiegen der Beinchen durch die federnden Anschläge (15, 16) in der Mitte des Biegezylinderhebelsystems (13) der Biegezylinder (17) gehalten ist.

5. Anordnung nach Anspruch 4, **dadurch gekennzeichnet,** daß das Biegezylinderhebelsystem (13) von den federnden Anschlägen (15) in Mittellage gehalten ist.

6. Verfahren zum automatischen Bestücken von Leiterplatten mit einer Anordnung nach den Ansprüchen 1 bis 5, **dadurch gekennzeichnet,** daß der Industrieroboter (1) mit dem Industrieroboter-Greifer (2) eine mit Sonder-Bauteilen zu bestückende Leiterplatte (4) aus einer Eingabestation holt und sie in den nicht angetriebenen, zunächst verriegelten x-y-Schlitten (3) mit einem Drehteller einsetzt, daß während dieses Vorganges die Bauteile von den Richtstationen (8) in die Bauteile-Greifer übergeben und die Beinchen ausgerichtet werden, daß anschließend die Wiege (9) mit den Bauteile-Greifern über die in dem Schlitten fixierte Leiterplatte einschwenkt, während der Industrieroboter (1) mit dem Industrieroboter-Greifer (2) den Schlitten und den Drehteller in die Bestückposition bewegt, wo die Bauteile eingesetzt und die Beinchen durch die Biegeköpfe abgebogen werden.

7. Verfahren nach Anspruch 6 zum Abbiegen der Beinchen, **dadurch gekennzeichnet,** daß nach dem Einsetzen eines Bauteils in die Leiterplatte derjenige Biegekopfzylinder (17) hochfährt, der den auf das Bauteil abgestimmten Biegekopf trägt, daß anschließend ein Biegezylinder (17) betätigt wird, der das Pendelsystem zuerst nach der einen und dann nach der anderen Seite auslenkt.

8. Verfahren nach Anspruch 7, **dadurch gekennzeichnet,** daß einer der Biegezylinder (17) zunächst die Hebelsysteme (12, 13) zusammen bewegt bis der Biegekopf (11) mit seinen Biegebacken (21) bei Vorhandensein eines Bauteilbeinchens auf dieses trifft und dadurch das Hebelsystem (12) anhält, während das Hebelsystem (13) gegen den Anschlag (16) weiterbewegt wird, bis der Schalter (22) anspricht, während im Fall, daß kein Beinchen vorhanden ist, der Schalter nicht betätigt wird und damit der automatische Ablauf angehalten wird.

9. Verfahren nach Anspruch 8, **dadurch gekennzeichnet,** daß nach dem Abbiegen eines Beinchens der zweite Biegezylinder (17) einen analogen Funktionsablauf einleitet.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A,D | ROBOTICS TODAY, Dezember 1983, Seiten 28-32; D. MILLER: "Robotic assembly in electronics manufacturing" <br> * Seite 29, linke Spalte, Absatz 3 - Seite 32, linke Spalte, Absatz 2; Figuren 3-5 * | 1 | H 05 K 13/04 |
| | --- | | |
| A | WO-A-8 304 365 (WESTERN ELECTRIC) <br> * Seite 4, Zeile 34 - Seite 5, Zeile 5; Figur 2 * | 1 | |
| | --- | | |
| A | FR-A-2 457 057 (JAZ) <br> * Seite 1, Zeilen 10-20; Figuren * | 1 | |
| | ----- | | RECHERCHIERTE SACHGEBIETE (Int. Cl.4) |
| | | | H 05 K |

Der vorliegende Recherchenbericht wurde für alle Patentansprüche erstellt.

| Recherchenort | Abschlußdatum der Recherche | Prüfer |
|---|---|---|
| DEN HAAG | 29-01-1986 | LOMMEL A. |